(19)

**Europäisches Patentamt**
**European Patent Office**
**Office européen des brevets**

(11) **EP 1 829 991 A1**

(12) **DEMANDE DE BREVET EUROPEEN**

(43) Date de publication:
**05.09.2007 Bulletin 2007/36**

(51) Int Cl.:
*C23D 5/00* (2006.01)    *C23D 5/02* (2006.01)
*B01J 21/06* (2006.01)    *B01J 35/00* (2006.01)

(21) Numéro de dépôt: **06290367.9**

(22) Date de dépôt: **02.03.2006**

(84) Etats contractants désignés:
**AT BE BG CH CY CZ DE DK EE ES FI FR GB GR HU IE IS IT LI LT LU LV MC NL PL PT RO SE SI SK TR**
Etats d'extension désignés:
**AL BA HR MK YU**

(71) Demandeur: **UGINE & ALZ FRANCE**
**92800 Puteaux (FR)**

(72) Inventeurs:
• **Damasse, Jean-Michel**
**92400 Bethune (FR)**
• **Charles, Jacques**
**71670 Le Breuil (FR)**

• **Langlet, Michel**
**38420 Le Versoud (FR)**
• **Permpoon, Siriwan**
**Bangkray 11000 Nonthaburi (TH)**
• **Joud, Jean-Charles**
**38240 Meylan (FR)**
• **Baroux, Bernard**
**74410 Saint Jorioz (FR)**

(74) Mandataire: **Plaisant, Sophie Marie et al**
**ARCELOR France**
**Arcelor Research Intellectual Property**
**5 rue Luigi Cherubini**
**93212 La Plaine Saint-Denis Cedex (FR)**

(54) **Tôle en acier inoxydable revêtue par un revêtement auto-nettoyant**

(57) L'invention a pour objet une tôle en acier inoxydable revêtue par un revêtement comprenant, dans l'ordre à partir de la surface de ladite tôle :
- une couche barrière d'oxyde ou d'oxy-hydroxyde métallique $MO_x$, ou de nitrure ou oxy-nitrure métallique $NM_x$, présentant une épaisseur comprise entre 5 et 1000 nm,
- une couche poreuse d'oxyde de titane $TiO_x$ présentant une épaisseur comprise entre 5 et 1000 nm, ladite couche de $TiO_x$ présentant une porosité volumique comprise entre 10 et 50% et une taille moyenne de pore comprise entre 0,5 et 100 nm et
- une couche supérieure d'oxyde de silicium ou d'oxy-hydroxyde $SiO_x$ présentant une épaisseur comprise entre 5 et 1000 nm.

L'invention concerne également le procédé de fabrication de cette tôle revêtue.

**Description**

La présente invention concerne une tôle en acier inoxydable revêtue sur au moins une de ses faces, par un revêtement auto-nettoyant, et le procédé de fabrication d'une telle tôle revêtue.

Pour des raisons à la fois de propreté et d'hygiène, il est essentiel d'éviter l'encrassement et de réduire l'adhésion des micro-organismes sur les surfaces par exemple, des bâtiments et des équipements de l'industrie agroalimentaire ou de l'industrie pharmaceutique. Généralement, on utilise l'acier inoxydable pour ce type d'application, car ce matériau présente une bonne résistance contre la corrosion et peut être facilement nettoyé par exemple avec de l'eau additionnée de détergent.

Afin de réduire l'entretien de telles surfaces, et d'éviter l'utilisation de détergent néfaste à l'environnement, il est connu de les revêtir par un revêtement de dioxyde de titane $TiO_2$, de préférence dans sa forme cristalline anatase. En effet, lorsqu'il est soumis aux radiations UV (radiation présentant une longueur d'onde inférieure à 380 nm), par exemple lors d'une exposition à la lumière d'une source fluorescente ou à la lumière solaire, le dioxyde de titane présente une activité à la fois photo-catalytique et super-hydrophile. L'activité photo-catalytique permet la dégradation partielle ou totale des composés organiques présents sur la surface. L'activité super-hydrophile photo-induite assure l'auto-nettoyabilité de la surface, dans la mesure où elle permet le lessivage des composés organiques résiduels par simple rinçage avec de l'eau sans adjonction de détergents ou par la pluie. Cependant, en l'absence de radiations UV, les surfaces traitées avec ce type de revêtement perdent rapidement leur activité photo-catalytique et super-hydrophile.

Le dioxyde de titane dopé à l'azote, obtenu par incorporation d'une faible quantité d'azote dans le dioxyde de titane dans sa forme anatase, présente une activité photo-catalytique et super-hydrophile lorsqu'il est exposé à une radiation lumineuse dans le visible (longueur d'onde comprise entre 400 et 700 nm). Cependant, en l'absence de lumière visible, les surfaces revêtues de dioxyde de titane dopé à l'azote perdent également rapidement leur activité photo-catalytique et super-hydrophile.

Les revêtements de l'art antérieur présentent donc l'inconvénient de perdre leur caractère auto-nettoyant en l'absence d'exposition à une radiation UV ou à une radiation lumineuse dans le visible selon le cas, lequel ne peut être régénéré qu'après une nouvelle exposition soit à une radiation UV, soit à une radiation lumineuse dans le visible.

Or, la plupart des équipements utilisés dans l'industrie agro-alimentaire, comme par exemple les cuisines collectives, les appareils ménagers et électro-ménagers sont souvent utilisés ou stockés dans des pièces privées de lumière UV, voir même de lumière visible, et les revêtements cités précédemment sont inefficaces pour en réduire ou faciliter l'entretien.

Le but de la présente invention est de remédier aux inconvénients des revêtements de l'art antérieur, et de mettre à disposition une tôle en acier inoxydable revêtue par un revêtement présentant une super-hydrophilie persistante pendant au moins trois semaines, sans qu'il soit nécessaire de la soumettre à une exposition aux radiations UV ou aux radiations lumineuses dans le visible pour régénérer la super-hydrophilie du revêtement.

La super-hydrophilie d'une surface se quantifie par l'évaluation de l'angle de contact de l'eau pure en surface. L'acier inoxydable présente un angle de contact de l'eau pure de l'ordre de 60°. Ainsi, si l'on répand de l'eau sur de l'acier inoxydable, des gouttelettes d'eau se forment. Sur une surface ayant une hydrophilie supérieure, les gouttelettes d'eau s'aplatissent. C'est ce qui est observé sur certains verres présentant un angle de contact de l'eau pure de l'ordre de 30°. Au sens de la présente invention, on entend par surface super-hydrophile une surface présentent un angle de contact de l'eau égal à 0°, ce qui permet à l'eau de former un film d'eau uniforme à la surface.

L'invention a donc pour objet une tôle en acier inoxydable revêtue sur au moins une de ses faces, par un revêtement comprenant, dans l'ordre à partir de la surface de ladite tôle :

- une couche barrière d'oxyde ou d'oxy-hydroxyde métallique $MO_x$, ou de nitrure ou d'oxy-nitrure métallique $NM_x$, présentant une épaisseur comprise entre 5 et 1000 nm, et de préférence comprise entre 20 et 850 nm,
- une couche poreuse d'oxyde de titane $TiO_x$ présentant une épaisseur comprise entre 5 et 1000 nm, de préférence comprise entre 20 et 500 nm, et avantageusement comprise entre 30 et 200 nm, ladite couche de $TiO_x$ présentant une porosité volumique comprise entre 10 et 50% et une taille moyenne de pore comprise entre 0,5 et 100 nm,
- une couche supérieure d'oxyde ou d'oxy-hydroxyde de silicium $SiO_x$ présentant une épaisseur comprise entre 5 et 1000 nm, et de préférence comprise entre 20 et 850 nm.

Le revêtement selon l'invention augmente la mouillabilité de l'eau sans qu'il soit nécessaire de l'exposer à des radiations UV ou des radiations lumineuses dans le visible. En raison du caractère super-hydrophile dudit revêtement, l'eau se répartit uniformément sur la surface de l'acier inoxydable traité, et forme un film d'eau uniforme. Si de surcroît la surface est verticale ou oblique, le film d'eau élimine une partie des impuretés qui se sont déposées sur la surface, en s'écoulant le long de la surface.

Enfin, lorsque la surface sèche, les traces d'eau que l'on retrouve habituellement sur les surfaces non traitées sont évitées, toujours en raison du caractère super-hydrophile du revêtement.

La tôle selon l'invention peut également comprendre les caractéristiques suivantes :

- ladite couche poreuse d'oxyde de titane $TiO_x$ est une couche de dioxyde de titane $TiO_2$,
- le dioxyde de titane $TiO_2$ se présente dans sa forme cristalline anatase,
- ladite couche poreuse de $TiO_x$ présente une porosité volumique comprise entre 20 et 40%, et une taille moyenne de pore comprise entre 1 et 20 nm,
- ladite couche supérieure d'oxyde de silicium est dense,
- ladite couche supérieure d'oxyde de silicium est une couche de dioxyde de silicium $SiO_2$,
- ladite couche barrière d'oxyde ou d'oxy-hydroxyde métallique $MO_x$ est choisie parmi les oxydes ou oxy-hydroxydes de silicium, d'étain, d'aluminium, seuls ou en mélange,
- ladite couche barrière de nitrure ou d'oxy-nitrure métallique est du nitrure ou de l'oxy-nitrure de silicium,
- ladite couche barrière est choisie parmi $SiO_2$, $SnO_2$, $Al_2O_3$, seul ou en mélange.

L'invention a également pour objet un procédé de fabrication de cette tôle en acier inoxydable revêtue, comprenant les étapes successives consistant à :

- déposer une couche barrière d'oxyde ou d'oxy-hydroxyde métallique $MO_x$, ou de nitrure ou oxy-nitrure métallique $NM_x$, sur au moins une des faces de ladite tôle en acier inoxydable,
- déposer par une méthode de dépôt sol-gel une couche poreuse d'oxyde de titane $TiO_x$ sur la surface de ladite couche barrière revêtant la tôle, et
- déposer une couche d'oxyde ou d'oxy-hydroxyde de silicium $SiO_x$ sur ladite couche d'oxyde de titane $TiO_x$.

Le procédé selon l'invention peut également comprendre les caractéristiques suivantes :

- ladite couche poreuse de $TiO_x$ est formée par application sur ladite couche barrière d'un sol polymérique comprenant 0,1 à 0,6 mol/l d'un précurseur organométallique de titane, ledit précurseur organométallique de titane pouvant être un alkoxyde de titane $Ti(OR)_4$, dans lequel R est une chaîne alkyle contenant 1 à 4 atomes de carbone,
- ladite couche poreuse de $TiO_x$ est formée par application sur ladite couche barrière d'une suspension cristalline comprenant 0,1 à 0,4 mol/l de nano-cristallites de dioxyde de titane dispersées dans un solvant dispersant,
- ladite couche barrière et/ou ladite couche supérieure de $SiO_x$ est déposée par une méthode sol-gel,
- ladite couche barrière est formée par application sur au moins une des faces de ladite tôle en acier inoxydable d'un sol polymérique comprenant 0,2 à 2 mol/l d'au moins un précurseur choisi parmi un composé organométallique et un sel métallique, ledit composé organométallique pouvant être un alkoxyde métallique $M(OR)_3$ ou $M(OR)_4$ dans lequel M est le silicium, l'aluminium ou l'étain, et R est une chaîne alkyle contenant 1 à 4 atomes de carbone, et ledit sel métallique pouvant être un nitrate ou un chlorure de silicium, d'aluminium ou d'étain,
- ladite couche supérieure de $SiO_x$ est formée par application sur ladite couche de $TiO_x$ d'un sol polymérique comprenant 0,2 à 2 mol/l d'un précurseur organométallique de silicium, ledit précurseur organométallique de silicium pouvant être un alkoxyde de silicium $Si(OR)_4$, dans lequel R est une chaîne alkyle contenant 1 à 4 atomes de carbone.

L'invention a également pour objet un équipement pour l'industrie agro-alimentaire ou un panneau pour bâtiment fabriqué à partir de cette tôle en acier inoxydable revêtue. Elle a encore pour objet l'utilisation de cette tôle en acier inoxydable revêtue pour éliminer par lavage à l'eau ou par l'eau de pluie, les salissures adhérant sur le revêtement sans qu'il soit nécessaire d'ajouter un détergent à l'eau, et sans qu'il soit nécessaire de soumettre ladite tôle à une radiation UV ou à une radiation lumineuse visible

Enfin, l'invention a pour objet le produit intermédiaire pouvant être obtenu, c'est à dire une tôle en acier inoxydable revêtue sur au moins une de ses faces, par un revêtement comprenant, dans l'ordre à partir de la surface de ladite tôle :

- une couche barrière d'oxyde ou d'oxy-hydroxyde métallique $MO_x$, ou de nitrure ou d'oxy-nitrure métallique $NM_x$, présentant une épaisseur comprise entre 5 et 1000 nm, et de préférence comprise entre 20 et 850 nm,
- une couche poreuse d'oxyde de titane $TiO_x$ présentant une épaisseur comprise entre 5 et 1000 nm, de préférence comprise entre 20 et 500 nm, et avantageusement comprise entre 30 et 200 nm, ladite couche de $TiO_x$ présentant une rugosité RMS comprise entre 0,5 et 50 nm, et de préférence comprise entre 1 et 20 nm, une porosité volumique comprise entre 10 et 50% et une taille moyenne de pore comprise entre 0,5 et 100 nm.

Les caractéristiques et avantages de la présente invention apparaîtront mieux au cours de la description qui va suivre, donnée à titre d'exemple non limitatif.

La tôle en acier inoxydable selon l'invention est revêtue par un revêtement présentant une super-hydrophilie naturelle persistante dans le temps, même si elle est maintenue plus de trois semaines à l'obscurité, sans qu'il soit nécessaire de la soumettre à une radiation UV ou lumineuse dans le visible pour activer la super-hydrophilie ou pour la régénérer. A cet effet, la tôle est revêtue sur au moins une de ses faces, par un revêtement comprenant, dans l'ordre à partir de la surface de l'acier, une couche barrière présentant une épaisseur supérieure à 5 nm, une couche poreuse d'oxyde de $TiO_x$ présentant une épaisseur comprise entre 5 et 1000 nm et une couche supérieure d'oxyde ou d'oxy-hydroxyde de silicium $SiO_x$ présentant une épaisseur supérieure à 5 nm.

Les inventeurs ont mis en évidence que pour conférer à la tôle un caractère super-hydrophile persistant dans le temps, la couche poreuse de $TiO_x$ devait présenter une porosité volumique comprise entre 10 et 50% et une taille moyenne de pore comprise entre 0,5 et 100 nm. De préférence, la porosité volumique de la couche de $TiO_x$ est comprise entre 20 et 40% et la taille moyenne de pore est comprise entre 1 et 20 nm.

La porosité volumique est estimée à partir de l'indice de réfraction de la couche de $TiO_x$ en utilisant la formule de Lorentz-Lorenz suivante :

$$1 - P/100 = (n^2 - 1) / (N^2 - 1) \times (N^2 + 2) / (n^2 + 2),$$

dans laquelle :

- n est l'indice de réfraction de la couche $TiO_x$,
- P est la porosité volumique de la couche de $TiO_x$, et
- N est l'indice de réfraction de l'oxyde de titane dense, c'est à dire l'oxyde de titane non poreux (par exemple N est égal à 2,5 pour le $TiO_2$ cristallisé dans sa forme anatase)

L'indice de réfraction est mesuré à la longueur d'onde de 632 nm au moyen d'un ellipsomètre Sentech.

La taille de pore est estimée par une imagerie de surface en utilisant un microscope électronique à balayage par effet de champ ZEISS Ultra 55.

Sans vouloir être lié par une quelconque théorie, les inventeurs pensent que les propriétés super-hydrophiles accrues obtenues selon l'invention, reposent sur des effets d'interface planaire mixte $SiO_x$-$TiO_x$ entre la couche supérieure de $SiO_x$ et la couche inférieure de $TiO_x$. En effet, avant le dépôt de la couche supérieure de $SiO_x$, la couche de $TiO_x$ présente une rugosité RMS comprise entre 0,5 et 50 nm, et de préférence entre 1 et 20 nm. Ainsi, en accroissant la rugosité RMS et la porosité de la couche de $TiO_x$, on augmente la surface de contact à l'interface, et les effets d'interfaces planaires peuvent être accrus. Toutefois, les inventeurs ont vérifié que pour une rugosité RMS supérieure à 50 nm, une porosité volumique supérieure à 50%, et une taille de pore supérieure à 100 nm, la qualité optique et la résistance mécanique de la couche de $TiO_x$ diminuent fortement. Une haute qualité optique de la couche de $TiO_x$ signifie que ladite couche n'induit aucune perte optique par diffusion de la lumière, ce qui permet de préserver l'aspect de surface de l'acier, et par exemple de préserver l'aspect brillant d'une tôle en acier qui aurait été préalablement polie. Selon l'invention, la résistance mécanique de ladite couche de $TiO_x$ est de préférence au moins égale à celle de la tôle en acier, cela permet notamment d'obtenir un revêtement résistant aux rayures et aux chocs. Lorsque la rugosité RMS est inférieure à 5 nm, la porosité volumique inférieure à 10% et la taille moyenne des pores inférieure à 0,5 nm, les inventeurs n'ont pas constaté de persistance durable significative de la super-hydrophilie.

La rugosité RMS correspond à une rugosité moyenne quadratique définie comme étant la moyenne quadratique des écarts du profil de rugosité par rapport à une ligne moyenne à l'intérieur d'une longueur de base. La rugosité RMS est mesurée au moyen d'un Microscope à Force Atomique Digital Instrument Nanoscope Multimode.

L'oxyde de titane $TiO_x$ peut être le dioxyde de titane, et peut se présenter sous sa forme amorphe, ou sa forme cristalline rutile ou anatase, ou un mélange de ses formes. Cependant, les meilleurs résultats en terme de super-hydrophilie ont été obtenus lorsque le dioxyde de titane se présentait sous sa forme cristalline anatase. La couche d'oxyde de titane $TiO_x$ est déposée sur la couche barrière, de préférence par une méthode de dépôt sol-gel. La méthode de dépôt sol-gel présente l'avantage de permettre de former, en une seule étape de dépôt, une couche de $TiO_x$ présentant une épaisseur uniforme comprise entre 20 et 200 nm, et ne présentant pas de fissures. Elle présente également l'avantage de permettre de contrôler la porosité de la couche de $TiO_x$ ainsi que la taille moyenne des pores. En outre, cette méthode de dépôt permet de produire des revêtements présentant une grande homogénéité et une grande pureté.

A cet effet, on dépose sur la surface de ladite couche barrière une solution liquide pouvant être soit un sol polymérique, soit avantageusement une suspension cristalline. En effet, les inventeurs ont observé qu'à épaisseur de couche de $TiO_x$ égale, l'utilisation de suspension cristalline permettait de conférer à la tôle une super-hydrophilie supérieure à celle obtenue avec un sol polymérique.

Le sol polymérique peut comprendre 0,1 à 0,6 mol/l d'un précurseur organométallique de titane et un solvant. Le précurseur organométallique de titane peut être un alkoxyde de titane $Ti(OR)_4$, dans lequel R est une chaîne alkyle contenant 1 à 4 atomes de carbone. Le précurseur organométallique de titane est de préférence l'isopropoxyde de titane.

La suspension cristalline peut comprendre 0,1 à 0,4 mol/l de nano-cristallites de dioxyde de titane dispersées dans un solvant dispersant tel que par exemple de l'eau ou un alcool. Les cristallites de dioxyde de titane sont de préférence sous la forme cristalline anatase.

Le dépôt du sol polymérique ou de la suspension cristalline est réalisé par une technique d'enduction en phase liquide, par exemple par trempé, par pulvérisation ou par étalement centrifuge. Pour accélérer la cristallisation de la couche de $TiO_x$ dans sa forme cristalline anatase ou rutile dans le cas d'un sol polymérique, ou évaporer plus rapidement le solvant dans le cas d'une suspension cristalline, on peut en outre faire subir à la couche de $TiO_x$ un traitement thermique en portant la tôle à une température comprise entre 100 et 600°C, et en la maintenant à cette température pendant une durée comprise entre 5 et 120 minutes.

L'épaisseur de la couche supérieure de $SiO_x$ n'est pas particulièrement limitée, cependant les inventeurs ont constaté qu'au-delà de 1000 nm, le caractère super-hydrophile du revêtement n'est pas amélioré.

Dans la mesure où la couche supérieure du revêtement est susceptible d'être soumise à des frottements, il est avantageux que la couche supérieure de $SiO_x$ soit dense, c'est à dire qu'elle présente une porosité volumique proche de 0%, ce qui confère au revêtement une résistance à l'abrasion sensiblement améliorée. En effet, plus la couche de $SiO_x$ est poreuse, plus sa résistance mécanique est faible et plus elle est sensible aux rayures.

La couche supérieure d'oxyde de silicium $SiO_x$ est de préférence une couche de dioxyde de silicium $SiO_2$.

Après avoir formé la couche de $TiO_x$ sur la couche barrière, la couche supérieure d'oxyde ou d'oxy-hydroxyde de silicium $SiO_x$ est de préférence déposée par une méthode sol-gel. Cette méthode de dépôt sol-gel présente l'avantage de permettre de former, en une seule étape de dépôt, une couche de $SiO_x$ présentant une épaisseur uniforme comprise entre 20 et 850 nm, et ne présentant pas de fissures. A cet effet, on dépose sur la surface de ladite couche de $TiO_x$ une solution liquide consistant en un sol polymérique comprenant 0,2 à 2 mol/l d'un précurseur et un solvant.

Le précurseur peut être un composé organométallique de silicium, ou encore un sel de silicium. Il réagit par hydrolyse et par polycondensation pour former $SiO_x$.

Le composé organométallique de silicium peut être un alkoxyde de silicium $Si(OR)_4$ dans lequel R est une chaîne alkyle contenant 1 à 4 atomes de carbone. Le précurseur préféré est le tétraéthoxy orthosilicate.

Le sel de silicium peut être par exemple un nitrate ou un chlorure de silicium.

Le dépôt de la solution liquide est réalisé par une technique d'enduction en phase liquide, par exemple par trempé, par pulvérisation ou par étalement centrifuge de la solution.

La méthode de dépôt sol-gel par la voie polymérique présente en outre l'avantage de former une couche de $SiO_x$ dense, c'est à dire une couche de $SiO_x$ dont la porosité volumique est proche de 0%, présentant une excellente résistance mécanique.

Pour accélérer la densification de la couche et évaporer plus rapidement le solvant, on peut en outre faire subir à la couche de $SiO_x$ un traitement thermique en portant la tôle à une température comprise entre 300 et 600°C, et la maintenant à cette température pendant une durée comprise entre 5 et 120 minutes.

La couche barrière incluse entre la tôle d'acier et la couche d'oxyde de titane $TiO_x$ permet d'éviter la diffusion des éléments métalliques de l'acier vers la couche de $TiO_x$. En effet, en l'absence de cette couche barrière, les inventeurs se sont rendus compte que les éléments métalliques de l'acier, comme par exemple le fer, contaminent la couche d'oxyde de titane, et que l'efficacité du revêtement en terme de super-hydrophilie s'en trouve rapidement réduite au cours du temps. Les inventeurs ont également constaté que, indépendamment de son rôle de barrière de diffusion, cette couche favorise également une super-hydrophilie accrue en créant une interface planaire supplémentaire avec la couche d'oxyde de titane.

La couche barrière présente une épaisseur comprise entre 5 et 1000 nm. En effet, les inventeurs ont constaté qu'en deçà de 5 nm, l'effet barrière est insuffisant et les éléments métalliques de l'acier migrent dans la couche supérieure de $TiO_x$, ce qui détériore la super-hydrophilie du revêtement. Au-delà de 1000 nm, l'efficacité de la couche barrière n'est pas améliorée.

La couche barrière peut être constituée d'au moins une couche d'oxyde ou d'oxy-hydroxyde métallique $MO_x$, choisie de préférence parmi les oxydes de silicium, d'étain, d'aluminium, seuls ou en mélange, et avantageusement choisie parmi $SiO_2$, $SnO_2$, $Al_2O_3$, seuls ou en mélange. Elle est avantageusement constituée d'une couche d'oxyde de silicium $SiO_2$. La couche barrière peut également être constituée par au moins une couche de nitrure ou oxy-nitrure métallique $NM_x$ comme par exemple une couche de nitrure ou d'oxy-nitrure de silicium.

La couche barrière d'oxyde ou d'oxy-hydroxyde métallique $MO_x$ est de préférence déposée sur au moins une des faces de la tôle, par une méthode de dépôt sol-gel, après avoir fait subir à une tôle en acier inoxydable un traitement thermique de type recuit-brillant ou recuit-décapé, selon que l'on cherche à obtenir un aspect de surface brillant ou au contraire mat. La méthode de dépôt sol-gel est préférée aux autres méthodes de dépôt, car elle permet de former, en une seule étape de dépôt, une couche de $MO_x$ présentant une épaisseur uniforme comprise entre 20 et 850 nm et ne présentant pas de fissures. En outre, cette méthode de dépôt permet de produire des revêtements présentant une grande homogénéité et une grande pureté. A cet effet, une solution liquide consistant en un sol polymérique comprenant 0,2 à 2 mol/l d'au moins un précurseur et un solvant, est déposée sur au moins une des faces de la tôle par une technique d'enduction en phase liquide, par exemple par trempé, par pulvérisation ou par étalement centrifuge de la solution.

Le précurseur peut être un composé organométallique, ou encore un nitrate ou un chlorure de métal. Il réagit par hydrolyse et par polycondensation pour former $MO_x$.

Le précurseur organométallique peut être un alkoxyde de métal $M(OR)_3$ ou $M(OR)_4$, dans lequel M est choisi parmi le silicium, l'étain, et l'aluminium, et R est une chaîne alkyle contenant 1 à 4 atomes de carbone. Le précurseur organométallique préféré est le tétraéthoxy orthosilicate.

Le précurseur constitué d'un nitrate ou d'un chlorure de métal peut être un nitrate de silicium ou un chlorure de silicium.

Pour accélérer la densification de la couche et évaporer plus rapidement le solvant, on peut en outre faire subir à la couche barrière un traitement thermique en portant la tôle à une température comprise entre 300 et 600°C, et en la maintenant à cette température pendant une durée comprise entre 5 et 120 minutes.

La couche barrière de nitrure ou oxy-nitrure métallique $NM_x$ peut être déposée par toute méthode conventionnelle permettant d'obtenir une couche mince de revêtement.

L'invention va à présent être illustrée par des exemples donnés à titre indicatif, non limitatif.

Pour cela, un premier lot d'échantillons (échantillons A) découpés dans une tôle en acier inoxydable de nuance 304 2R ont été revêtus avec une couche de $SiO_2$ par une méthode d'étalement centrifuge en utilisant un sol polymérique comprenant 1,5 mol/l de tétraéthoxy orthosilicate, de l'éthanol absolu, 3,3 mol/l d'eau désionisée et de l'acide chlorhydrique pour ajuster le pH du sol polymérique à 3,5. Les échantillons revêtus ont ensuite été portés à 500°C, et maintenus à cette température pendant 120 minutes, pour former une couche de dioxyde de silicium $SiO_2$ d'épaisseur 190 nm.

Un second lot d'échantillons (échantillons B et D) découpés dans la même tôle en acier inoxydable de nuance 304 2R que précédemment ont été revêtus par un revêtement bi-couche comprenant une première couche de $TiO_2$ en contact avec la surface de l'acier, et une couche supérieure de $SiO_2$.

Un troisième lot d'échantillons (échantillons C et E) également découpés dans la même tôle en acier inoxydable de nuance 304 2R ont été revêtus par un revêtement tricouche selon l'invention comprenant une première couche de $SiO_2$ en contact avec la surface de l'acier, une couche intermédiaire de $TiO_2$ et une couche supérieure de $SiO_2$.

Les épaisseurs des couches de $SiO_2$ sont de 190 nm pour chacun des lots B, C, D et E. Les couches de $SiO_2$ des revêtements bicouches et tricouches sont déposées selon la même procédure que celle mentionnée précédemment pour le premier lot d'échantillons, et elles sont traitées thermiquement à 500°C pendant 120 minutes après chaque dépôt de couche.

La couche de $TiO_2$ est formée par dépôt sol-gel à partir :

- d'une suspension cristalline comprenant 0,24 mol/l de nano-cristallites de $TiO_2$ sous forme cristalline anatase dispersée dans de l'éthanol absolu (échantillon B et C), ou
- d'un sol polymérique comprenant 0,4 mol/l d'isopropoxyde de titane dilué dans de l'éthanol absolu en présence de 0,32 mol/l d'eau, et d'acide chlorhydrique pour ajuster le pH à 1,3 (échantillons D et E).

Dans les deux cas, la couche de $TiO_2$ a été traitée thermiquement à 500°C, pendant 120 minutes, et les caractérisations par diffraction des rayons X montrent qu'elles sont constituées de cristallites d'anatase.

La couche de $TiO_2$ obtenue par dépôt de la suspension cristalline et traitée à 500°C pendant 120 minutes, présente une épaisseur de 40 nm, une rugosité RMS de 5 nm (avant dépôt de la couche supérieure de $SiO_2$), une taille moyenne de pore de 15 nm, et une porosité volumique de 30%.

La couche de $TiO_2$ obtenue par dépôt du sol polymérique et traitée à 500°C pendant 120 minutes, présente une épaisseur de 160 nm, une rugosité RMS de 1 nm (avant dépôt de la couche supérieure de $SiO_2$), une taille moyenne de pore de 5 nm, et une porosité volumique de 15%.

On obtient ainsi les échantillons suivants :

- Echantillon A : tôle en acier inoxydable revêtue par une couche de $SiO_2$.
- Echantillon B : tôle en acier inoxydable revêtue par un revêtement bicouche constitué d'une couche de $TiO_2$ obtenue à partir d'une suspension cristalline, et d'une couche supérieure de $SiO_2$.
- Echantillon C : tôle en acier inoxydable revêtue par un revêtement tricouche constitué d'une couche barrière de $SiO_2$, d'une couche de $TiO_2$ obtenue à partir d'une suspension cristalline, et d'une couche supérieure de $SiO_2$.
- Echantillon D : tôle en acier inoxydable revêtue par un revêtement bicouche constitué d'une couche de $TiO_2$ obtenue à partir d'un sol polymérique, et d'une couche supérieure de $SiO_2$.
- Echantillon E : tôle en acier inoxydable revêtue par un revêtement tricouche constitué d'une couche barrière de $SiO_2$, d'une couche de $TiO_2$ obtenue à partir d'un sol polymérique, et d'une couche supérieure de $SiO_2$.

Après avoir formé les revêtements mono, bi ou tricouches, on laisse vieillir les échantillons en les maintenant à l'obscurité, c'est à dire en l'absence de tout rayonnement lumineux pendant 84 jours. Leur super-hydrophilie est régulièrement évaluée, en mesurant l'angle de contact que forment des gouttes d'eau pure sur le revêtement, au moyen d'une caméra vidéo connectée à un goniomètre KRUSS G 10. Les résultats des mesures sont regroupés dans le tableau 1.

Tableau I

| | Angle de contact de l'eau (°) mesuré en fonction du vieillissement de l'échantillon (nombre de jours dans l'obscurité) | | | | | | | |
|---|---|---|---|---|---|---|---|---|
| | 0 jour | 7 jours | 14 jours | 21 jours | 28 jours | 56 jours | 70 jours | 84 jours |
| Echantillon A | 2° | 0° | 3° | 5° | 5,5° | n.m. | n.m. | n.m. |
| Echantillon B | 0° | 0° | 4° | 5,5° | 6,5° | n.m. | n.m. | 14° |
| *Echantillon C | 0° | 0° | 0° | 0° | 0° | 0° | 0° | 4,5° |
| Echantillon D | 0° | 0° | 3,5 | 5 | 5,5 | n.m. | n.m. | n.m. |
| *Echantillon E | 0° | 0° | 0° | 0° | 0° | 18,5° | n.m. | n.m. |
| *selon l'invention<br>n.m. : non mesuré | | | | | | | | |

Les résultats du tableau 1 montrent bien que les tôles en acier inoxydable revêtues par des revêtements tricouche selon l'invention présentent une super-hydrophilie naturelle et persistante que ne présentent pas de simples revêtements $SiO_2$ déposés sur des tôles en acier inoxydable. Sans vouloir être lié par une quelconque théorie, les inventeurs pensent que cet effet est lié à la présence d'interfaces planaires de type $SiO_2$-$TiO_2$.

La plus longue persistance de super-hydrophilie d'une tôle en acier inoxydable revêtue d'un revêtement tricouche à partir d'une suspension cristalline de $TiO_2$ montre l'influence du mode de fabrication des revêtements qui permet de contrôler une porosité et une rugosité adaptée à l'interface $SiO_2$-$TiO_2$ et ainsi d'augmenter la surface spécifique à cette interface.

Quel que soit le mode de fabrication, la plus courte persistance de super-hydrophilie de la tôle en acier inoxydable revêtue par des revêtements bicouches est attribuée à la contamination du $TiO_2$ par les éléments issus de l'acier lors du dépôt de $TiO_2$ en phase liquide et/ou lors du traitement thermique. Les revêtements bicouches ainsi formés ne présentent pas de propriétés hydrophiles accrues par rapport à une simple couche de $SiO_2$ déposée sur une tôle en acier inoxydable. La contamination de la couche de $TiO_2$ dans un revêtement bicouche par les éléments provenant de l'acier, n'exerce aucune influence positive sur les propriétés super-hydrophiles.

Par ailleurs, les inventeurs ont constaté que la super-hydrophilie naturelle sans irradiation UV et sans exposition à la lumière visible disparaît au bout d'une certaine durée de vieillissement. La super-hydrophilie du revêtement bicouche obtenu à partir d'une suspension cristalline selon l'invention est sensiblement réduite au bout de 14 jours, et l'angle de contact de l'eau mesuré à la surface de ce revêtement après 84 jours de vieillissement est de 14°. La super-hydrophilie s'atténue beaucoup moins au bout de 84 jours pour le revêtement tricouche obtenu à partir d'une suspension cristalline selon l'invention et l'angle de contact mesuré après ce vieillissement est de 4,5°.

L'atténuation de la super-hydrophilie est attribuée à la contamination de la couche de $SiO_2$ externe par les espèces carbonées issues de l'atmosphère ambiante. Les inventeurs se sont rendus compte que la super-hydrophilie des revêtements tricouches selon l'invention pouvait être facilement régénérée par aspersion, pendant au moins une minute, d'eau à une température comprise entre 20 et 30°C du revêtement, sans irradiation UV et sans exposition à la lumière visible.

Après 84 jours de maintien à l'obscurité, les échantillons B et C ont ainsi été aspergés par un flux d'eau à 25°C, pendant 1 mn, puis ont été séchés par un gaz comprimé. L'angle de contact que forment des gouttes d'eau pure déposées sur le revêtement a été mesuré au moyen d'une caméra vidéo connectée à un goniomètre KRUSS G 10 :

- dès que les échantillons sont secs, et
- après un nouveau vieillissement des échantillons en les maintenant à l'obscurité pendant 7 jours.

Les résultats sont regroupés dans le tableau II

Tableau II

| | Angle de contact après vieillissement de 84 jours (°) | Angle de contact après aspersion d'eau à 25°C pendant 1 mn (°) | Angle de contact après un nouveau vieillissement de 7 jours (°) |
|---|---|---|---|
| Echantillon B | 14 | 5 | 14 |
| *Echantillon C | 4,5 | 0 | 0 |
| * selon l'invention | | | |

La différence de comportement des échantillons B et C montre bien qu'un revêtement tricouche selon l'invention restreint la contamination carbonée de l'acier inoxydable au court d'un vieillissement prolongé. Cela permet d'éliminer facilement cette faible contamination par un simple rinçage à l'eau. Dans le cas d'un revêtement bicouche, la tôle en acier inoxydable se contamine plus vite, ce qui empêche l'élimination efficace de la contamination carbonée dans de mêmes conditions opératoires.

## Revendications

1. Tôle en acier inoxydable revêtue sur au moins une de ses faces, par un revêtement comprenant, dans l'ordre à partir de la surface de ladite tôle :

   - une couche barrière d'oxyde ou d'oxy-hydroxyde métallique $MO_x$, ou de nitrure ou oxy-nitrure métallique $NM_x$, présentant une épaisseur comprise entre 5 et 1000 nm,
   - une couche poreuse d'oxyde de titane $TiO_x$ présentant une épaisseur comprise entre 5 et 1000 nm, ladite couche de TiOx présentant une rugosité RMS comprise entre 0,5 et 50 nm, une porosité volumique comprise entre 10 et 50% et une taille moyenne de pore comprise entre 0,5 et 100 nm.

2. Tôle selon la revendication 1, **caractérisée en ce que** la rugosité RMS de ladite couche poreuse de $TiO_x$ est comprise entre 1 et 20 nm.

3. Tôle en acier inoxydable revêtue sur au moins une de ses faces, par un revêtement comprenant, dans l'ordre à partir de la surface de ladite tôle :

   - une couche barrière d'oxyde ou d'oxy-hydroxyde métallique $MO_x$, ou de nitrure ou oxy-nitrure métallique $NM_x$, présentant une épaisseur comprise entre 5 et 1000 nm,
   - une couche poreuse d'oxyde de titane $TiO_x$ présentant une épaisseur comprise entre 5 et 1000 nm, ladite couche de $TiO_x$ présentant une porosité volumique comprise entre 10 et 50% et une taille moyenne de pore comprise entre 0,5 et 100 nm, et
   - une couche supérieure d'oxyde ou d'oxy-hydroxyde de silicium $SiO_x$ présentant une épaisseur comprise entre 5 et 1000 nm.

4. Tôle selon l'une quelconque des revendications 1 à 3, **caractérisée en ce que** l'épaisseur de ladite couche poreuse d'oxyde de titane $TiO_x$ est comprise entre 20 et 500 nm.

5. Tôle selon la revendication 4, **caractérisée en ce que** l'épaisseur de ladite couche poreuse de $TiO_x$ est comprise entre 30 et 200 nm.

6. Tôle selon l'une quelconque des revendications 1 à 5, **caractérisée en ce que** la porosité volumique de ladite couche poreuse de $TiO_x$ est comprise entre 20 et 40%.

7. Tôle selon l'une quelconque des revendications 1 à 6, **caractérisée en ce que** la taille moyenne de pore de ladite couche poreuse de $TiO_x$ comprise entre 1 et 20 nm.

8. Tôle selon l'une quelconque des revendications 1 à 7, **caractérisée en ce que** ladite couche poreuse d'oxyde de titane $TiO_x$ est une couche de dioxyde de titane $TiO_2$.

9.  Tôle selon la revendication 8, **caractérisée en ce que** le dioxyde de titane $TiO_2$ se présente dans sa forme cristalline anatase.

10. Tôle selon l'une quelconque des revendications 3 à 9, **caractérisée en ce que** l'épaisseur de ladite couche supérieure d'oxyde ou d'oxy-hydroxyde de silicium $SiO_x$ est comprise entre 20 et 850 nm.

11. Tôle selon l'une quelconque des revendications 3 à 10, **caractérisée en ce que** ladite couche supérieure d'oxyde de silicium est une couche de dioxyde de silicium $SiO_2$.

12. Tôle selon l'une quelconque des revendications 1 à 11, **caractérisée en ce que** l'épaisseur de ladite couche barrière est comprise entre 20 et 850 nm.

13. Tôle selon l'une quelconque des revendications 1 à 12, **caractérisée en ce que** ladite couche barrière d'oxyde ou d'oxy-hydroxyde métallique est choisie parmi les oxydes ou oxy-hydroxydes de silicium, d'étain, d'aluminium, seuls ou en mélange.

14. Tôle selon la revendication 13, **caractérisée en ce que** ladite couche barrière est choisie parmi $SiO_2$, $SnO_2$, $Al_2O_3$, seuls ou en mélange.

15. Tôle selon l'une quelconque des revendications 1 à 12, **caractérisée en ce que** ladite couche barrière de nitrure ou d'oxy-nitrure métallique $NM_x$ est du nitrure ou de l'oxy-nitrure de silicium.

16. Procédé de fabrication d'une tôle en acier inoxydable revêtue selon l'une quelconque des revendications 3 à 15, comprenant les étapes successives consistant à :

    - déposer une couche barrière d'oxyde ou d'oxy-hydroxyde métallique $MO_x$ ou de nitrure ou d'oxy-nitrure métallique $NM_x$, sur au moins une des faces de ladite tôle en acier inoxydable,
    - déposer par une méthode sol-gel une couche poreuse d'oxyde de titane $TiO_x$ sur la surface de ladite couche barrière revêtant la tôle en acier inoxydable, et
    - déposer une couche supérieure d'oxyde ou d'oxy-hydroxyde de silicium $SiO_x$ sur ladite couche d'oxyde de titane $TiO_x$.

17. Procédé selon la revendication 16, **caractérisé en ce que** ladite couche poreuse de $TiO_x$ est formée par application sur ladite couche barrière d'un sol polymérique comprenant 0,1 à 0,6 mol/l d'un précurseur organique de titane.

18. Procédé selon la revendication 17, **caractérisé en ce que** ledit précurseur organique de titane est un alkoxyde de titane $Ti(OR)_4$, dans lequel R est une chaîne alkyle contenant 1 à 4 atomes de carbone.

19. Procédé selon la revendication 16, **caractérisé en ce que** ladite couche poreuse de $TiO_x$ est formée par application sur ladite couche barrière d'une suspension cristalline comprenant 0,1 à 0,4 mol/l de nano-cristallites de dioxyde de titane dispersées dans un solvant dispersant.

20. Procédé selon l'une quelconque des revendications 16 à 19, **caractérisé en ce que** ladite couche barrière est déposée par une méthode sol-gel.

21. Procédé selon la revendication 20, **caractérisé en ce que** ladite couche barrière de $MO_x$ est formée par application sur au moins une des faces de ladite tôle d'un sol polymérique comprenant 0,2 à 2 mol/l d'au moins un précurseur choisi parmi un composé organométallique et un sel métallique.

22. Procédé selon la revendication 21, **caractérisé en ce que** ledit composé organométallique est un alkoxyde de métal $M(OR)_3$ ou $M(OR)_4$, dans lequel le métal M est le silicium, l'aluminium ou l'étain, et R est une chaîne alkyle contenant 1 à 4 atomes de carbone.

23. Procédé selon la revendication 21, **caractérisé en ce que** ledit sel métallique est un nitrate ou un chlorure de silicium, d'aluminium ou d'étain.

24. Procédé selon l'une quelconque des revendications 16 à 23, **caractérisé en ce que** ladite couche supérieure d'oxyde ou d'oxy-hydroxyde de silicium $SiO_x$ est déposée par une méthode sol-gel.

**25.** Procédé selon la revendication 24, **caractérisé en ce que** ladite couche supérieure de SiO$_x$ est formée par application sur ladite couche de TiO$_x$ d'un sol polymérique comprenant 0,2 à 2 mol/l d'un précurseur organométallique de silicium.

**26.** Procédé selon la revendication 25, **caractérisé en ce que** ledit précurseur organométallique de silicium est un alkoxyde de silicium Si(OR)$_4$, dans lequel R est une chaîne alkyle contenant 1 à 4 atomes de carbone.

**27.** Equipement pour l'industrie agro-alimentaire fabriqué à partir d'une tôle en acier inoxydable revêtue selon l'une quelconque des revendications 3 à 15.

**28.** Panneau pour bâtiment fabriqué à partir d'une tôle en acier inoxydable revêtue selon l'une quelconque des revendications 3 à 15.

**29.** Utilisation de la tôle en acier inoxydable selon l'une quelconque des revendications 3 à 15, pour éliminer par lavage à l'eau, les salissures adhérant sur ledit revêtement sans qu'il soit nécessaire d'ajouter un détergent à l'eau, et sans qu'il soit nécessaire de soumettre ladite tôle à une radiation UV ou à une radiation lumineuse visible.

**Office européen
des brevets**

## RAPPORT DE RECHERCHE EUROPEENNE

Numéro de la demande

EP 06 29 0367

### DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | PATENT ABSTRACTS OF JAPAN vol. 1998, no. 01, 30 janvier 1998 (1998-01-30) -& JP 09 228332 A (TOTO LTD), 2 septembre 1997 (1997-09-02) * abrégé * * alinéas [0011], [0013], [0018], [0022], [0024], [0026] * ----- | 1-29 | INV. C23D5/00 C23D5/02 B01J21/06 B01J35/00 |
| A | EP 0 850 204 A (SAINT-GOBAIN VITRAGE; SAINT-GOBAIN GLASS FRANCE) 1 juillet 1998 (1998-07-01) * revendications 1,2,15,16,21,22 * ----- | 1-29 | |
| A | DE 10 2004 033620 A1 (LIU, WEN-CHUAN) 2 février 2006 (2006-02-02) * revendication 1; figure * ----- | 1,3 | |
| A | US 2005/221098 A1 (AZZOPARDI MARIE-JOSE ET AL) 6 octobre 2005 (2005-10-06) * alinéas [0001] - [0005], [0010] - [0012], [0015] - [0017] * ----- | 1,3 | DOMAINES TECHNIQUES RECHERCHES (IPC) |
| A | EP 1 304 366 A (TOTO LTD) 23 avril 2003 (2003-04-23) * alinéas [0092] - [0094]; revendications 1-17 * ----- | 1,3 | C23D B01J C03C |
| A | DATABASE WPI Section Ch, Week 200479 Derwent Publications Ltd., London, GB; Class G,page 02, AN 2004-797224 XP002392294 -& CN 1 522 795 A (UNIV YUNNAN) 25 août 2004 (2004-08-25) * abrégé * ----- | 1,3 | |

Le présent rapport a été établi pour toutes les revendications

| Lieu de la recherche | Date d'achèvement de la recherche | Examinateur |
|---|---|---|
| Munich | 27 juillet 2006 | Lilimpakis, E |

CATEGORIE DES DOCUMENTS CITES

X : particulièrement pertinent à lui seul
Y : particulièrement pertinent en combinaison avec un
   autre document de la même catégorie
A : arrière-plan technologique
O : divulgation non-écrite
P : document intercalaire

T : théorie ou principe à la base de l'invention
E : document de brevet antérieur, mais publié à la
   date de dépôt ou après cette date
D : cité dans la demande
L : cité pour d'autres raisons
...................................................................................
& : membre de la même famille, document correspondant

EPO FORM 1503 03.82 (P04C02)

**ANNEXE AU RAPPORT DE RECHERCHE EUROPEENNE**
**RELATIF A LA DEMANDE DE BREVET EUROPEEN NO.**                EP 06 29 0367

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

27-07-2006

| Document brevet cité au rapport de recherche | Date de publication | Membre(s) de la famille de brevet(s) | Date de publication |
|---|---|---|---|
| JP 09228332 A | 02-09-1997 | JP 3588206 B2 | 10-11-2004 |
| EP 0850204 A | 01-07-1998 | AT 286858 T | 15-01-2005 |
| | | AT 210097 T | 15-12-2001 |
| | | AU 7087596 A | 01-04-1997 |
| | | BR 9610604 A | 17-02-1999 |
| | | CZ 9800784 A3 | 12-08-1998 |
| | | DE 69617705 D1 | 17-01-2002 |
| | | DE 69617705 T2 | 08-08-2002 |
| | | DE 69634178 D1 | 17-02-2005 |
| | | DE 69634178 T2 | 05-01-2006 |
| | | DK 850204 T3 | 02-04-2002 |
| | | ES 2236066 T3 | 16-07-2005 |
| | | ES 2168506 T3 | 16-06-2002 |
| | | FR 2738813 A1 | 21-03-1997 |
| | | WO 9710186 A1 | 20-03-1997 |
| | | JP 11512337 T | 26-10-1999 |
| | | JP 2005205411 A | 04-08-2005 |
| | | JP 2005199275 A | 28-07-2005 |
| | | JP 2005225758 A | 25-08-2005 |
| | | JP 2005213142 A | 11-08-2005 |
| | | PL 325527 A1 | 03-08-1998 |
| | | PT 1132351 T | 31-05-2005 |
| | | PT 850204 T | 31-05-2002 |
| | | TR 9800459 T1 | 22-06-1998 |
| | | US 6103363 A | 15-08-2000 |
| | | US 6326079 B1 | 04-12-2001 |
| DE 102004033620 A1 | 02-02-2006 | AUCUN | |
| US 2005221098 A1 | 06-10-2005 | AU 2003262138 A1 | 27-10-2003 |
| | | BR 0309272 A | 22-02-2005 |
| | | CA 2482112 A1 | 23-10-2003 |
| | | CN 1662467 A | 31-08-2005 |
| | | EP 1497236 A1 | 19-01-2005 |
| | | FR 2838735 A1 | 24-10-2003 |
| | | WO 03087005 A1 | 23-10-2003 |
| | | JP 2005528313 T | 22-09-2005 |
| | | MX PA04010165 A | 03-02-2005 |
| EP 1304366 A | 23-04-2003 | AUCUN | |
| CN 1522795 A | 25-08-2004 | AUCUN | |

EPO FORM P0460

Pour tout renseignement concernant cette annexe : voir Journal Officiel de l'Office européen des brevets, No.12/82